# EUROPEAN PATENT SPECIFICATION

(11) **EP 4 320 390 B1**
(45) Date of publication and mention of the grant of the patent: **02.09.2026**
(21) Application number: 21939503.5
(22) Date of filing: 08.04.2021
(51) Int. Cl.: F24C 7/08, H03K 17/968, G05G 1/10, H03K 17/969

(54) **COOKING APPLIANCE COMPRISING ROTARY CONTROL SWITCH**
KOCHGERÄT UMFASSEND EIN DREHSCHALTER
APPAREIL DE CUISSON COMPRENANT UN COMMUTATEUR DE COMMANDE ROTATIF

(43) Date of publication of application: 14.02.2024
(73) Proprietor: Ferel Elektronik San. Ve Tic. A.S., Silivri/Istanbul (TR)
(72) Inventor: BILGIC, Hasan Bahadir, Silivri/Istanbul (TR); MUMCU, Sinan, Silivri/Istanbul (TR)
(74) Representative: Soylu, Ekrem
(86) International application number: PCT/TR2021/050330
(87) International publication number: WO 2022/231530

(56) References cited:
- EP-A2- 0 805 467
- WO-A1-2013/041514
- WO-A1-2013/098063
- WO-A1-2018/188574
- CN-U- 204 189 066
- DE-A1- 3 705 010
- US-A- 3 946 225

## Description

### TECHNICAL FIELD

The invention relates to a a cooking device, particularly an oven comprising a rotary switch in particular a rotary switch which is encoded to allow selection of an operating mode.

### BACKGROUND OF THE ART

Domestic appliances, particularly the oven, various operation modes are selected by means of a rotary switch and the commands are transferred to the open or closed electronic control circuit, e.g. a processor, by encoding as an electronic signal pattern for the corresponding mode of operation. The rotary switch mounted to the shaft of the rotary knob initiates the operation of the functional elements e.g. top electric heater, bottom electric heater, fan in accordance with the predetermined operation mode of the indicated angular position by rotating the rotary knob to the selected station. The rotary switch usually consists of a universal coding contact disc and a wiper that sweep the disc radially from its center to outer periphery.

EP0805467B1 discloses a switch provides a coded output signal pattern characteristic of each switch position, by providing different connections between a contact slider and coded contact paths of a universal coding contact disc for each switch position. Pref. the contact slider is fitted directly to the rotary setting shaft of the switch, with the coded contact paths arranged coaxial to the setting shaft, with non-linearly distributed coding positions around the periphery of the coding contact disc.

Further prior art can be found in DE3705010A1.

### BRIEF DESCRIPTION OF THE INVENTION

The object of the invention is to provide cooking device with compact rotary switch adapted to the rotary control knob for a cooking appliance.

In order to achieve above objective, invention relates to a cooking device, particularly an oven comprising a rotary switch, comprising a contact disc having a contact pattern; a sensor assembly providing an electronic signal pattern by engaging with the contact pattern when the rotary knob is rotated, and a controller connected to the sensor assembly in a signal transmitting manner and activating a cooking mode corresponding to the transmitted electronic signal pattern. The rotary switch is further comprising a plurality of consecutive open contact tracks and closed contact tracks of the contact pattern are following each other along a ring form of the contact disc and the sensor assembly is engaging the contact pattern along a reading zone radially partially corresponding to the ring in the contact pattern such that the sensor assembly provides a unique data block in the electronic signal pattern for each rotation angle of the sensor assembly. A different data block is obtained at the smallest angular displacement in the rotary knob, for example, with an angular displacement of two adjacent contact tracks, such as open or closed contact tracks. In this way, sufficient data block variant can be obtained to operate all the different cooking configurations of a cooking appliance with a hollow rotary knob.

According to the invention, the contact pattern is in the form of a single ring on the contact disc. Since there is no contact pattern other than a single ring on the contact disc, maximum gaps can be obtained in the center of the rotary knob, and a display or a different functional element can preferably be adapted to this area.

In a preferred embodiment of the invention, the contact disc is rotatably secured to the rotary knob. When the rotary knob is rotated as the rotation angle, the contact disc is angularly displaced and the open or closed contact track distribution corresponding to the reading area in the sensor assembly changes. By securing the sensor assembly against the contact disc, for example, in the oven body, a replaceable contact disc structure is obtained together with the rotary knob.

According to the invention, the open contact track and the closed contact tracks are distributed in equal radial distance on the ring. A different unique data set is generated by forming a step in successive equal angles of rotation of the rotary encoder. In a possible embodiment, an uneven and longer distance between the open and closed contact tracks can be arranged. In this case, a contact pattern is created in which the user can notice the transition between the modes, such as the transition from the selection between baking modes to the selection between grill modes.

In a preferred embodiment of the invention, the rotation angle of the contact disc is arranged in accordance with the formula 360/T degrees while T is equal to number of every one of the open and closed contact tracks on the contact pattern. T is an integer and is greater than one. In this case, for example, if the number of contact tracks is 10, contact tracks are arranged in a ring-shaped contact pattern at an angle of 36°.

According to the invention, the sensor assembly is having a reading element corresponding to each of the open contact track and the closed contact track in the reading zone. Each contact track is read by the corresponding reader element in the sensor assembly and transmitted to the controller as a unique data block consisting of bits of the information of the open and closed contact tracks located in the reading zone. The predetermined cooking mode is determined by comparing the bit pattern specific to the rotation angle of the data block with a pattern in a memory module of the controller, and the related electrical units of the cooking device are activated according to the cooking mode selected by the controller.

In a preferred embodiment of the invention, the contact disc is in the form of a ring-shaped plate with a flat lateral wall with a contact pattern canvas and provided with a central inner space. This form can be directly a part of the rotary knob, or it can be adapted to the rotary knob as a seperate part. In this way, it is possible to read the unique data block with the sensor assembly located near the lateral wall of the plate, perpendicularly or at an angle.

In a preferred embodiment of the invention, contact pattern consist of 2^{x} open contact tracks and closed contact tracks in total wherein x is an integer, and the reading zone is configured such that simultaneously reads breaking status of open contact track and closed contact track in the reading zone simultaneously. In this way, a contact pattern is obtained that allows the use of a compact sensor, and a sufficient number of unique data blocks are obtained when the operating functions of the cooking device are observed. Preferably, a selection is made such that 3<x<7. This configuration makes it possible to select the most ergonomic rotary knob for the user.

A preferred embodiment of the invention is a cooking device, particularly an oven, with a rotary switch as described above.

### BRIEF DESCRIPTION OF THE FIGURES

Figure 1 is a front view of a built-in oven equipped with a representative embodiment of the inventive rotary switch.
Figure 2 is a front schematic view of a representative embodiment of the inventive rotary switch in a cooking mode selection.
Figure 3 is a schematic representation of successive data blocks allowing the oven to select three different cooking modes.

### DETAILED DESCRIPTION OF THE INVENTION

In this detailed explanation, the invention is explained without any limitation and only with reference to examples to better explain the subject matter invention.

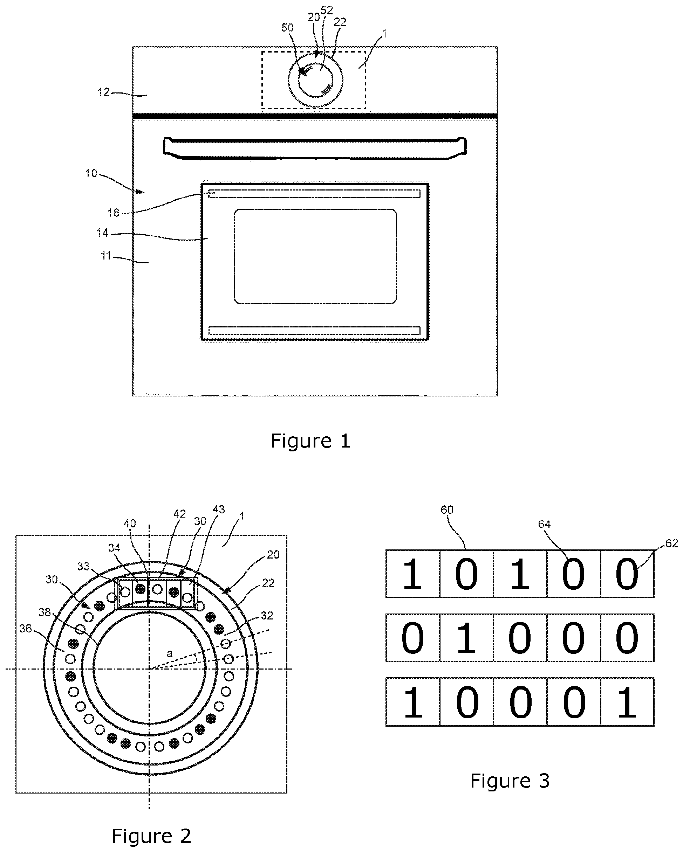

Figure 1 shows a domestic built-in oven from the front. The oven has a cooking chamber (14) surrounded by a casing (10) and accessible to the casing (10) by a hinged front cover (11). In the cooking chamber (14), an electrical heating element (16) is electrically connected to a controller (1) such that activated in a cooking mode. A control panel (12) is provided in the form of a flat panel extending from one end to the other above the front cover (11). A rotary knob (20) is disposed in the middle of the control panel (12). The rotary knob (20) can rotate 360° on a shaft (not shown) extending vertically towards the rear of the control panel (12). The controller (1) having an electronic printed board is fixed behind the control panel (12) in line with the rotary knob (20). The rotary knob (20) is in the form of a cylindrical cup and can be grasped manually by the operator from an outer periphery (22). A display assembly (50) is mounted therein by providing a circular gap in the central part of the rotary knob (20). A circular display (52) is disposed at the front of the display assembly (50).

Figure 2 shows schematically a rotary switch from the front comprising a rotary knob (20) and a ring-shaped contact disc (30) adapted to the rotary knob (20) and a sensor assembly (40) provided thereon. The contact disc (30) is secured coaxially with the rotary knob (20) between the outer periphery (22) of the rotary knob (20) and an opposite inner part. In the inner side, a central gap is surrounded, which supports the display assembly (50). A contact pattern (32) is formed on the contact disk (30) in alignment with a circular path coaxial with the center of the contact disk (30). The contact pattern (32) consists of open contact tracks (33) in the radial distributed opening structure in the same form and distance from each other, and closed contact tracks (34) consisting of closed parts between them. Open and closed contact tracks (33, 34) are arranged in 5-bits, sometimes adjacent to each other, sometimes separate, creating a code. The sensor assembly (40) comprises an optical sensor with detecting parts adjacent to each other. The detecting parts are of five segmented structures, each aligned with an open contact track (33) or a closed contact track (34) at the corresponding portion of the ring-shaped contact disc (30). In this way, at any radial angular position of the contact disc (30), the sensor assembly (40) reads five different bits of data. To achieve this, a light source (not shown) with an LED element is mounted on the controller (1), and the light source illuminates the contact disk (30) from the inner side, opposed to the sensor assembly (40). The beam radiated from the light source can only reach the sensor assembly (40) by passing through the corresponding open contact track (33). On the other hand, closed contact tracks (34) mask the light source (not shown). Thus, the detection part aligned to the closed contact track (34) does not generate any electrical signals. The light passing through the opening (33) generates an electrical signal in the sensor assembly (40) and transmits it to the controller (1) to which it is connected via the cable (not shown).

The inner space (38) of the contact disc (30) is adjacent to the inside of the coaxial rotary knob (20). The inner space (38) of the contact disc (30) does not block the cavity. Thus, the display assembly (50) can be inserted into the cavity by being pushed from the outside.

Figure 3 shows sequential unique data blocks located in a reading zone (60) delimited by the reader portion of the sensor assembly (40) when the variant of the contact pattern (32) is changed at different successive operational angular positions (a) of the rotary knob (20). a Generating a unique data that does not repeat itself is ensured by the light from the light source reaching the sensor assembly (40) is masked in a different pattern by the contact pattern (32) in each operational angular position (a) change. This data is transmitted to the controller (1) as an electrical signal. The unique data block comprises a successive first field (62) and a second field (64). The first field (62) and the second field (64) produce a value of 1 or 0, respectively, corresponding to the open or closed contact track (33, 34), which differs with each operational angular position (a) change. A unique data block is obtained by combining the generated values with the bit values in a total of five fields in the reading zone. Since the total number of fields is x=5 and two-bit open or closed contact traces (33, 34), a total of 32 unique data blocks are created, 2⁵ equal to the number of contact traces (T). **In** this case, the number of stations of the rotary knob (20) is defined by the operating angle (a) of 360°/32 = 11.25°. This calculation is based on a full-rotation operating plan of the rotary encoder. For example, if a 320° rotation adjustment limit is set, it will be 320/32 = 10°.

By means of a processor and memory module (not shown) on the electronic circuit board, the controller (1) compares the data supplied from the sensor assembly (40) with the predetermined cooking mode configurations and determines the selected cooking mode by turning the rotary knob (20). Accordingly, initiates the cooking operation in the cooking chamber (14) by activating the electrical heating element (16) by energizing it. Rotational direction can be found by determining the operational angular position (a) the rotary adjustment button (20) as described above, by means of set a reference as starting point by obtaining corresponding encoding determined by the sensor assembly (40). Thus, with the rotary adjustment button (20), it is possible for the rotary switch not only to determine the cooking mode, but also to set the temperature. A preset time information is displayed on the screen (52) by detecting shut-down reference data of the oven of Fig. 1 with by means of the controller (1). The contact disc (30) provides radial displacement of the part opposite the sensor assembly (40) fixed in the casing (10) when the user rotates the rotary knob (20) by grasping from the outer periphery (22). The optical sensor (42) is activated by the controller (1) and check which of the detection section (43) has a voltage during the rotation. The detection sections (43) correspond to the open contact track (33) generate the voltage with the light beam coming from the light source and send it to the controller (1). The controller (1) transmits the corresponding cooking mode to the display device (50) as an electrical signal, according to the selected 5-bit, and ensures that the cooking mode information is shown on the display (52). When the user observes the cooking mode he wants to select on the display (52), he fixes the new operational angular position (a). Thus, the controller (1) switches to the temperature setting mode. Display (52) shows the minimum temperature for the selected cooking mode. The user again turns the rotary knob (20) clockwise or counterclockwise to increase and decrease the temperature setting, respectively. This process determines the direction in which the rotary knob (20) moves by taking the selected code of the sensor assembly (40) as reference, by comparing it with the operational angular position (a) from the memory module of the controller (1), increasing or decreasing the temperature accordingly. When the selection is complete, the controller (1) continues to drive the thermostat (not shown) such that the temperature of the cooking chamber (14) is heated to the value closest to the selected value. Moreover, it energizes the relevant functional element, for example the electric heating element (16), according to the selected cooking mode. The cooking time selection on the oven or the setting of other parameters (for example, alarm) can also be performed by turning the rotary knob (20), similar to the description above.

**REFERENCE NUMBERS**

| | | | |
|---|---|---|---|
| 1 | Controller | 34 | Closed contact track |
| 10 | Casing | 36 | Lateral wall |
| 11 | Front cover | 38 | Inner space |
| 12 | Control panel | 40 | Sensor assembly |
| 14 | Cooking chamber | 42 | Optical sensor |
| 16 | Electric heating element | 43 | Detection section |
| 20 | Rotary knob | 60 | Reading zone |
| 22 | Outer periphery | 62 | First field |
| 30 | Contact disc | 64 | Second field |
| 32 | Contact pattern | a | Rotation angle |
| 33 | Open contact track | x | Number of fields |
| | | T | Number of contact tracks |

## Claims

1. A cooking device, particularly an oven comprising; a rotary switch; comprising a rotary knob (20); a contact disc (30) having a contact pattern (32); a light-source; an optical sensor assembly (40); providing an electronic signal pattern by engaging with the contact pattern (32) when the rotary knob (20) is rotated and a controller (1) connected to the sensor assembly (40) in a signal transmitting manner and activating a cooking mode corresponding to the transmitted electronic signal pattern; the contact pattern (32) comprises a plurality of consecutive open contact tracks (33), through which beam radiated from the light source only reach the sensor assembly (40) and closed contact tracks (34) mask the light source are following each other along a ring form of the contact disc (30); and **characterized in that** the contact pattern (32) is in the form of a single ring on the contact disc (30) and the open contact tracks (33) and the closed contact tracks (34) are distributed in equal radial distance along the ring form; the sensor assembly (40) is engaging the contact pattern (32) along a reading zone (60) radially partially corresponding to the ring in the contact pattern (32) such that the sensor the sensor assembly (40) provides a unique data block (62, 64) consisting of bits of the information of the open and closed contact tracks (33, 34) located in the reading zone in the electronic signal pattern for each rotation angle (a) of the sensor assembly (40).

2. A cooking device according to any one of the preceding claims, wherein the contact disc (30) is rotatably secured to the rotary knob (20).

3. A cooking device according to claim 1, wherein the rotation angle (a) of the contact disc (30) is arranged in accordance with the formula 360/T degrees while T is equal to number of every one of the open and closed contact tracks (33, 34) on the contact pattern (32).

4. A cooking device according to any one of the preceding claims, wherein the sensor assembly (40) is having an optical sensor (42) corresponding to each of the open contact track (33) and the closed contact track (34) in the reading zone (60).

5. A cooking device according to any one of the preceding claims, wherein the contact disc (30) is in the form of a ring-shaped plate with a flat lateral wall (36) with a contact pattern (32) canvas and provided with a central inner space (38).

6. A cooking device according to any one of the preceding claims, contact pattern (32) consist of 2^{x} open contact tracks (33) and closed contact tracks (34) in total wherein x is an integer and the reading zone (60) is configured such that simultaneously reads breaking status of open contact track (33) and closed contact track (34) in the reading zone (60) simultaneously.

## Patentansprüche

1. Gargerät, insbesondere Backofen, umfassend: einen Drehschalter, umfassend einen Drehknopf (20); eine Kontaktscheibe (30) mit einem Kontaktmuster (32); eine Lichtquelle; eine optische Sensoranordnung (40), die ein elektronisches Signalmuster bereitstellt, indem sie mit dem Kontaktmuster (32) in Eingriff tritt, wenn der Drehknopf (20) gedreht wird; und eine Steuerung (1), die mit der Sensoranordnung (40) signalübertragend verbunden ist und einen dem übertragenen elektronischen Signalmuster entsprechenden Garmodus aktiviert; wobei das Kontaktmuster (32) eine Vielzahl von aufeinanderfolgenden offenen Kontaktspuren (33), durch die der von der Lichtquelle abgestrahlte Strahl allein die Sensoranordnung (40) erreicht, und geschlossenen Kontaktspuren (34), die die Lichtquelle maskieren, umfasst, welche einander entlang einer Ringform der Kontaktscheibe (30) folgen; **dadurch gekennzeichnet, dass** das Kontaktmuster (32) in Form eines einzigen Rings auf der Kontaktscheibe (30) ausgebildet ist und die offenen Kontaktspuren (33) und die geschlossenen Kontaktspuren (34) in gleichem radialem Abstand entlang der Ringform verteilt sind; die Sensoranordnung (40) mit dem Kontaktmuster (32) entlang einer Lesezone (60) in Eingriff tritt, die radial teilweise dem Ring in dem Kontaktmuster (32) entspricht, derart, dass die Sensoranordnung (40) für jeden Drehwinkel (a) der Sensoranordnung (40) einen eindeutigen Datenblock (62, 64) bereitstellt, der aus Bits der Information der in der Lesezone befindlichen offenen und geschlossenen Kontaktspuren (33, 34) in dem elektronischen Signalmuster besteht.

2. Gargerät nach einem der vorhergehenden Ansprüche, wobei die Kontaktscheibe (30) drehbar an dem Drehknopf (20) befestigt ist.

3. Gargerät nach Anspruch 1, wobei der Drehwinkel (a) der Kontaktscheibe (30) gemäß der Formel 360/T Grad ausgelegt ist, wobei T gleich der Anzahl einer jeden der offenen und geschlossenen Kontaktspuren (33, 34) auf dem Kontaktmuster (32) ist.

4. Gargerät nach einem der vorhergehenden Ansprüche, wobei die Sensoranordnung (40) einen optischen Sensor (42) aufweist, der jeder der offenen Kontaktspur (33) und der geschlossenen Kontaktspur (34) in der Lesezone (60) entspricht.

5. Gargerät nach einem der vorhergehenden Ansprüche, wobei die Kontaktscheibe (30) in Form einer ringförmigen Platte mit einer flachen Seitenwand (36) mit einer Kontaktmuster (32)-Trägerfläche ausgebildet und mit einem zentralen Innenraum (38) versehen ist.

6. Gargerät nach einem der vorhergehenden Ansprüche, wobei das Kontaktmuster (32) insgesamt aus 2X offenen Kontaktspuren (33) und geschlossenen Kontaktspuren (34) besteht, wobei x eine ganze Zahl ist, und die Lesezone (60) derart ausgebildet ist, dass sie gleichzeitig den Unterbrechungszustand der offenen Kontaktspur (33) und der geschlossenen Kontaktspur (34) in der Lesezone (60) gleichzeitig liest.

## Revendications

1. Dispositif de cuisson, en particulier four, comprenant : un commutateur rotatif comprenant un bouton rotatif (20) ; un disque de contact (30) présentant un motif de contact (32) ; une source lumineuse ; un ensemble capteur optique (40) fournissant un motif de signal électronique en venant en prise avec le motif de contact (32) lorsque le bouton rotatif (20) est tourné ; et un dispositif de commande (1) relié à l'ensemble capteur (40) de manière à transmettre des signaux et activant un mode de cuisson correspondant au motif de signal électronique transmis ; le motif de contact (32) comprenant une pluralité de pistes de contact ouvertes consécutives (33), à travers lesquelles le faisceau émis par la source lumineuse atteint uniquement l'ensemble capteur (40), et de pistes de contact fermées (34) masquant la source lumineuse, lesquelles se suivent les unes les autres le long d'une forme annulaire du disque de contact (30) ; **caractérisé en ce que** le motif de contact (32) se présente sous la forme d'un anneau unique sur le disque de contact (30) et **en ce que** les pistes de contact ouvertes (33) et les pistes de contact fermées (34) sont réparties à distance radiale égale le long de la forme annulaire ; l'ensemble capteur (40) venant en prise avec le motif de contact (32) le long d'une zone de lecture (60) correspondant radialement en partie à l'anneau dans le motif de contact (32), de telle sorte que l'ensemble capteur (40) fournit, pour chaque angle de rotation (a) de l'ensemble capteur (40), un bloc de données unique (62, 64) constitué de bits de l'information des pistes de contact ouvertes et fermées (33, 34) situées dans la zone de lecture dans le motif de signal électronique.

2. Dispositif de cuisson selon l'une quelconque des revendications précédentes, dans lequel le disque de contact (30) est fixé de manière rotative au bouton rotatif (20).

3. Dispositif de cuisson selon la revendication 1, dans lequel l'angle de rotation (a) du disque de contact (30) est agencé conformément à la formule 360/T degrés, T étant égal au nombre de chacune des pistes de contact ouvertes et fermées (33, 34) sur le motif de contact (32).

4. Dispositif de cuisson selon l'une quelconque des revendications précédentes, dans lequel l'ensemble capteur (40) présente un capteur optique (42) correspondant à chacune de la piste de contact ouverte (33) et de la piste de contact fermée (34) dans la zone de lecture (60).

5. Dispositif de cuisson selon l'une quelconque des revendications précédentes, dans lequel le disque de contact (30) se présente sous la forme d'une plaque annulaire avec une paroi latérale plate (36) pourvue d'une surface support du motif de contact (32) et muni d'un espace intérieur central (38).

6. Dispositif de cuisson selon l'une quelconque des revendications précédentes, dans lequel le motif de contact (32) est constitué au total de 2X pistes de contact ouvertes (33) et pistes de contact fermées (34), x étant un nombre entier, et la zone de lecture (60) est configurée de telle sorte qu'elle lit simultanément l'état d'interruption de la piste de contact ouverte (33) et de la piste de contact fermée (34) dans la zone de lecture (60) simultanément.
